(19) Europäisches Patentamt
European Patent Office
Office européen des brevets

(11) **EP 2 405 449 B1**

(12) **EUROPEAN PATENT SPECIFICATION**

(45) Date of publication and mention
of the grant of the patent:
**16.08.2017 Bulletin 2017/33**

(51) Int Cl.:
*H01B 1/22* *(2006.01)*          *H01B 5/14* *(2006.01)*
*H01L 21/28* *(2006.01)*        *H01L 21/288* *(2006.01)*
*H01L 21/3205* *(2006.01)*     *H01L 23/52* *(2006.01)*
*H05K 1/09* *(2006.01)*          *H01L 23/532* *(2006.01)*

(21) Application number: **10748492.5**

(22) Date of filing: **02.03.2010**

(86) International application number:
**PCT/JP2010/001400**

(87) International publication number:
**WO 2010/100893 (10.09.2010 Gazette 2010/36)**

(54) **ELECTRICALLY CONDUCTIVE PASTE COMPOSITION AND ELECTRICALLY CONDUCTIVE FILM FORMED BY USING THE SAME**

ZUSAMMENSETZUNG FÜR EINE ELEKTRISCH LEITENDE PASTE UND DARAUS GEFORMTER ELEKTRISCH LEITENDER FILM

COMPOSITION DE PÂTE ÉLECTRIQUEMENT CONDUCTRICE ET FILM ÉLECTRIQUEMENT CONDUCTEUR FORMÉ À L'AIDE DE CELLE-CI

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **06.03.2009 JP 2009053811**

(43) Date of publication of application:
**11.01.2012 Bulletin 2012/02**

(73) Proprietor: **Toyo Aluminium Kabushiki Kaisha Osaka-shi, Osaka 541-0056 (JP)**

(72) Inventors:
• **LAI, Gaochao**
**Osaka-shi**
**Osaka 541-0056 (JP)**
• **HASHIZUME, Yoshiki**
**Osaka-shi**
**Osaka 541-0056 (JP)**
• **KAWASHIMA, Katsura**
**Osaka-shi**
**Osaka 541-0056 (JP)**
• **KOIKE, Kazunori**
**Osaka-shi**
**Osaka 541-0056 (JP)**

(74) Representative: **Grünecker Patent- und Rechtsanwälte**
**PartG mbB**
**Leopoldstraße 4**
**80802 München (DE)**

(56) References cited:
JP-A- 5 298 917        JP-A- 7 014 428
JP-A- 10 188 670      JP-A- 2001 338 529
JP-A- 2002 109 957    JP-A- 2005 197 118
JP-A- 2005 200 734    JP-A- 2009 105 045
US-A1- 2006 231 803   US-A1- 2007 246 690

**EP 2 405 449 B1**

**Description**

TECHNICAL FIELD

The present invention relates generally to electrically conductive paste compositions and electrically conductive films using the same. More particularly, the present invention relates to an electrically conductive paste composition suitable for use in forming electrodes or wires in electronic devices and an electrically conductive film formed by using the same.

BACKGROUND ART

Since aluminum is light and exhibits excellent electrical conductivity, the aluminum is used as a material for forming electrodes or wires in many electronic devices such as a semiconductor device, a solar cell, and an electronic display. Conventionally, in general, an electrically conductive film containing the aluminum is formed through employing a vacuum process method such as a CVD method and a PVD method (a sputtering method, a vacuum deposition method, or the like), the obtained aluminum-containing electrically conductive film is selectively removed through employing an etching method using a photolithographic technique, thereby forming patterns of electrodes or wires containing the aluminum. Since these methods require expensive vacuum apparatuses, not only great amounts of energy are consumed but also it is difficult to evenly form electrodes or wires on a substrate having a large area. Therefore, this causes a problem in that yields are poor and manufacturing cost is high. In addition, when the vacuum process method is employed, it is difficult to form an electrically conductive film on a substrate having a surface which is not of a planate shape but of an irregular shape and to form a thick electrically conductive film having a film thickness less than or equal to 1 $\mu$m.

In recent years, an electrically conductive paste obtained by dispersing aluminum particles in a binder has been developed. Proposed is a method in which this electrically conductive paste is pattern-printed through employing a screen printing method or the like and is subjected to firing, thereby forming patterns of electrodes or wires containing the aluminum. Since in this method, pattern printing is conducted by directly applying the aluminum-containing electrically conductive paste and the patterns of electrodes and wires are thereby formed, manufacturing cost is inexpensive. However, electrical conductivity of the obtained aluminum-containing film is low, properties of adhesion with a substrate as well as surface smoothness properties of the film also are poor, and therefore, it is technically difficult to form fine patterns by using such an aluminum-containing film.

In order to improve performance of the aluminum-containing film formed by employing the above-mentioned application method, a variety of proposals with respect to an aluminum-containing electrically conductive paste has been made.

For example, Japanese Patent Application Laid-Open Publication No. 2008-108716 (hereinafter, referred to as Patent Document 1) discloses that an electrically conductive paste is prepared by using a mixed powder of 60 to 90 parts by weight of an aluminum powder and 10 to 40 parts by weight of a silver powder, this electrically conductive paste is fired at a low temperature, and a dense fired film is thereby formed, thereby improving the performance of the aluminum-containing film.

In addition, Japanese Patent Application Laid-Open Publication No. 5-298917 (hereinafter, referred to as Patent Document 2) discloses that in order to obtain an electrically conductive aluminum paste composition which enhances oxidation resistance properties of the aluminum and exhibits excellent electrical conductivity even when the electrically conductive aluminum paste composition is fired in an air atmosphere, at least one kind of a powder selected from the group consisting of carbon, germanium, tin, a metal hydride compound, and a metal phosphide compound is added to a mixture of an aluminum powder and a glass powder.

Furthermore, Japanese Patent Application Laid-Open Publication No. 2005-1193 (hereinafter, referred to as Patent Document 3) discloses that in order to obtain an electrically conductive laminated member excellent in surface electrical conductivity, an undercoat layer and a metal thin film layer are sequentially formed on a surface of a substrate, and further thereon, as an upper layer, a topcoat layer having coating composition composed of a resin component, a hardening component, and a component of a flaky aluminum powder and a metal oxide powder such as a tin oxide powder and an indium oxide powder is formed.

CITATION LIST

PATENT LITERATURE

[Patent Document 1] Japanese Patent Application Laid-Open Publication No. 2008-108716
[Patent Document 2] Japanese Patent Application Laid-Open Publication No. 5-298917
[Patent Document 3] Japanese Patent Application Laid-Open Publication No. 2005-1193

SUMMARY OF THE INVENTION

TECHNICAL PROBLEM

However, when the electrically conductive paste containing the mixed powder of the aluminum powder and the silver powder, disclosed in Patent Document 1, is fired, because a small amount of the silver gets mixed in the aluminum, there caused is a problem in that a sheet resistance value of the obtained electrically conductive film is increased, that is, electrical conductivity of the electrically conductive film is reduced.

In addition, although the additive such as the germanium and the tin, contained in the electrically conductive aluminum paste composition disclosed in Patent Document 2, brings about a firing effect, because the additive component remains in the aluminum after the firing, there caused is a problem in that a sheet resistance value of the obtained electrically conductive film is increased, that is, electrical conductivity of the electrically conductive film is reduced.

Furthermore, although the additive such as the tin oxide and the indium oxide in the electrically conductive laminated member disclosed in Patent Document 3 brings about a firing effect, because the additive component remains as an impurity in the aluminum after the firing, there caused is a problem in that a sheet resistance value of the electrically conductive laminated member is increased, that is, electrical conductivity of the electrically conductive laminated member is reduced.

In addition, because of the remaining impurity, it is likely that physical properties, such as surface smoothness properties and properties of adhesion with a base material, of the formed electrically conductive film are also reduced.

Therefore, objects of the present invention are to provide an electrically conductive paste composition capable of easily and inexpensively forming, on a variety of substrates or in electronic devices, electrically conductive films such as electrodes and wires excellent in electrical conductivity, surface smoothness properties, and properties of adhesion with a base material; and an electrically conductive film formed by using the above-mentioned electrically conductive paste composition.

SOLUTION TO PROBLEM

In order to solve the problems of the conventional technology, the present inventors have devoted themselves to studies. As a result, the present inventors found that with attention focused on specific physical property values of aluminum particles, in particular, a shape of each of the aluminum particles and a surface state thereof, for example, an oxygen content, aluminum particles each having a specific shape and having a specific oxygen content are used as aluminum particles contained in a paste composition and an electrically conductive film is formed by using an electrically conductive paste composition containing the above-mentioned aluminum particles, thereby allowing the above-mentioned objects to be achieved. Based on the findings, the electrically conductive paste composition according to the present invention and the electrically conductive film formed by using the above-mentioned electrically conductive paste composition have the following features.

The electrically conductive paste composition according to the present invention includes flaky aluminum particles as an electrically conductive powder, an average thickness of the flaky aluminum particles is less than or equal to 0.8 $\mu$m, and a ratio of an oxygen content to a unit surface area of the flaky aluminum particles is less than or equal to 15 mg/m$^2$.

In the electrically conductive paste composition according to the present invention, it is preferable that an average aspect ratio which is a ratio of an average particle diameter of the flaky aluminum particles to the average thickness of the flaky aluminum particles is greater than or equal to 30 and less than or equal to 500.

In addition, in the electrically conductive paste composition according to the present invention, it is preferable that each of the flaky aluminum particles is covered with an organic film.

In this case, it is preferable that the organic film includes at least one kind selected from the group consisting of a fatty acid, an aliphatic amine, an aliphatic alcohol, an aliphatic ester compound, and a resin.

It is preferable that the electrically conductive paste composition according to the present invention further includes at least one kind selected from the group consisting of an organic vehicle, glass frit, and a metal alkoxide.

An electrically conductive film according to the present invention is an electrically conductive film formed by using the electrically conductive paste composition having any of the above-described features, and an average surface roughness Ra thereof is less than or equal to 1 $\mu$m.

In addition, in the electrically conductive film according to the present invention, it is preferable that in a chart obtained by an X-ray diffraction analysis of the electrically conductive film, a peak intensity ratio of a diffraction peak corresponding to a (400) plane of y-Al$_2$O$_3$ to a diffraction peak corresponding to a (200) plane of Al is less than or equal to 0.2.

Furthermore, it is preferable that in cross section observation of the electrically conductive film according to the present invention, an area occupancy rate of the flaky aluminum particles in a cross section of the electrically conductive film is greater than or equal to 80% and an average inclination angle of the flaky aluminum particles is less than or equal to 3°.

## ADVANTAGEOUS EFFECTS OF THE INVENTION

As described above, according to the present invention, by using flaky aluminum particles, as an electrically conductive powder contained in a paste composition, whose average thickness is less than or equal to 0.8 $\mu$m and whose ratio of an oxygen content to a unit surface area of the particles is less than or equal to 15 mg/m$^2$, an effect which enhances densification of the aluminum particles upon firing can be obtained. Furthermore, through forming an electrically conductive film on a substrate by using the paste composition according to the present invention, electrically conductive films such as electrodes and wires excellent in electrical conductivity, surface smoothness properties, and properties of adhesion with a base material can be obtained.

## DESCRIPTION OF EMBODIMENTS

An electrically conductive paste composition according to the present invention includes flaky aluminum particles as an electrically conductive powder. In the electrically conductive paste composition, an average thickness of the flaky aluminum particles is less than or equal to 0.8 $\mu$m and a ratio of an oxygen content to a unit surface area of the flaky aluminum particles is less than or equal to 15 mg/m$^2$.

In the paste composition according to the present invention, the flaky aluminum particles are used as the electrically conductive powder. As compared with the conventional particulate aluminum particles, by using the flaky aluminum particles, contact areas among the particles are drastically increased, thereby bringing about effects which enhance densification of the aluminum particles upon firing and electrical conductivity of a film obtained after firing.

<Flaky aluminum particles>

The average thickness of the flaky aluminum particles is less than or equal to 0.8 $\mu$m. Preferably, the average thickness of the flaky aluminum particles is less than or equal to 0.6 $\mu$m. Although the lower limit of the average thickness of the flaky aluminum particles is not particularly limited, in consideration of a strength and a surface state of the particles as well as difficulties in handling in manufacturing processes, the lower limit thereof is 0.01 $\mu$m. The average thickness of the flaky aluminum particles can be calculated by using a hiding power and a density of the particles and can also be measured in an atomic force microscope (AFM) photograph of the particles.

It is preferable that a particle diameter of each of the flaky aluminum particles is greater than or equal to 1 $\mu$m and less than or equal to 100 $\mu$m and it is more preferable that the particle diameter of each of the flaky aluminum particles is greater than or equal to 2 $\mu$m and less than or equal to 20 $\mu$m. If the particle diameter of each of the flaky aluminum particles falls below 1 $\mu$m, because an arrangement of the flaky aluminum particles is worsened, contacting among the flaky aluminum particles becomes insufficient, thereby making it impossible to attain favorable electrical conductivity. Also if the particle diameter of the flaky aluminum particles exceeds 100 $\mu$m, because the arrangement of the flaky aluminum particles is worsened, favorable contacting among the flaky aluminum particles cannot be maintained, thereby worsening the electrical conductivity.

In addition, it is preferable that an average aspect ratio, which is a ratio of an average particle diameter of the flaky aluminum particles to an average thickness of the flaky aluminum particles, is greater than or equal to 30 and less than or equal to 500, and it is further preferable that the average aspect ratio is greater than or equal to 40 and less than or equal to 400. If the average aspect ratio is less than 30, because flaking of the aluminum particles is incomplete and contacting among the particles is not sufficient, it is likely that a predetermined densification effect cannot be attained. On the other hand, if the average aspect ratio exceeds 500, because the flaking of the aluminum particles becomes excessive and a surface state of each of the aluminum particles is thereby worsened, whereby, for example, a surface oxygen content may be increased and electrical conductivity and adhesion properties of the formed film may be reduced. The average aspect ratio is calculated by using a ratio between an average particle diameter and an average thickness of the particles (an average particle diameter [$\mu$m] / an average thickness [$\mu$m]). The average particle diameter of the particles is obtained by calculating a volume average from a particle size distribution measured by employing the heretofore known particle size distribution measurement method such as a laser diffraction method, a micromesh sieve method, and a Coulter counter method.

The flaky aluminum particles may be prepared by employing any method. For example, the flaky aluminum particles may be prepared by exfoliating an aluminum thin film, formed on a surface of a plastic film through vapor deposition, from the surface of the plastic film and thereafter, by crushing the aluminum thin film, or the flaky aluminum particles may be prepared by pulverizing aluminum particles, obtained through employing the conventionally heretofore known atomizing method, in the presence of an organic solvent by means of a ball mill.

In general, for example, a parting agent such as a resin or a grinding aid such as a higher fatty acid is adherent to a surface of each of the aluminum particles (thin film) obtained by the above-mentioned vapor deposition process or to a surface of each of the flaky aluminum particles obtained by pulverizing the aluminum particles by means of the ball mill. In the present invention, however, flaky aluminum particles each having a surface to which the parting agent or the grinding aid is adherent may be used, or the flaky aluminum particles each having a surface from which the parting agent or the grinding aid is removed may be used. Even when either of the flaky aluminum particles are used, the above-mentioned effects can be attained. As the grinding aid in a case where the pulverizing is performed by means of the ball mill, for example, a fatty acid such as an oleic acid and a stearic acid, an aliphatic amine, an aliphatic amide, an aliphatic alcohol, an ester compound, and the like are cited. These have effect to suppress unnecessary oxidation of a surface of each of the flaky aluminum particles and to improve electrical conductivity and the like of the formed film.

In the electrically conductive paste composition according to the present invention, it is preferable that each of the flaky aluminum particles is coated with an organic film. In this case, an organic substance, such as the grinding aid or a resin, being present on a surface of each of the flaky aluminum particles suppresses oxidation of the aluminum even in a process of firing the electrically conductive paste according to the present invention and realizes higher electrical conductivity. It is preferable that the organic film includes at least one kind selected from the group consisting of a fatty acid, an aliphatic amine, an aliphatic alcohol, an aliphatic ester compound, and a resin. Specifically, as the fatty acid, an oleic acid, a stearic acid and a lauric acid; as the aliphatic amine, a stearylamine and a lauryl amine; as the aliphatic alcohol, a stearyl alcohol and an oleyl alcohol; as the aliphatic ester compound, a stearic acid amide, butyl stearate, an oleyl acid phosphate, and a 2-ethylhexyl acid phosphate; and as the resin, an acrylic resin, a urethane resin, an epoxy resin, a polyester resin, a cellulosic resin, and the like are cited as examples.

In addition, a ratio of an oxygen content to a unit surface area of the flaky aluminum particles is less than or equal to 15 mg/m$^2$. Preferably, the above-mentioned ratio of the oxygen content is less than or equal to 12 mg/m$^2$. If the ratio of the oxygen content exceeds 15 mg/m$^2$, densification of the aluminum particles is slowed and it is likely that electrical conductivity of the obtained film is reduced. This ratio of the oxygen content is calculated by obtaining a ratio between an oxygen content in the flaky aluminum particles measured by employing an inert gas fusion infrared absorption method and a specific surface area measured by employing a nitrogen adsorption BET method (oxygen content [mg/g] / specific surface area [m$^2$/g]).

Here, it is preferable that a content of the flaky aluminum particles contained in the electrically conductive paste composition according to the present invention is greater than or equal to 5% by mass and less than or equal to 60% by mass and it is further preferable that the content thereof is greater than or equal to 10% by mass and less than or equal to 40% by mass. When the content of the flaky aluminum particles is within the above-mentioned range, because properties of application to a variety of substrates become favorable, properties of adhesion of a film, formed after firing, to a substrate become favorable.

<Organic vehicle>

As an organic vehicle contained in the electrically conductive paste composition according to the present invention, a vehicle obtained by dissolving a binder resin in an organic solvent is used.

A component of the binder resin constituting the organic vehicle contained in the electrically conductive paste composition according to the present invention is not particularly limited, and a resin such as an ethyl cellulose based resin, an alkyd based resin, a polyester based resin, and an acrylic based resin can be used. Preferable is a resin which is completely burnt and decomposed at a firing temperature through applying the electrically conductive paste composition according to the present invention onto a substrate and thereafter, heating the electrically conductive paste composition. In addition, as the organic solvent, an isopropyl alcohol, toluene, a glycol ether based solvent, a terpineol based solvent, or the like can be used. It is preferable that a content of the organic vehicle in the electrically conductive paste composition according to the present invention is greater than or equal to 40% by mass and less than or equal to 95% by mass. When the content of the organic vehicle is within the above-mentioned range, the electrically conductive paste composition including the flaky aluminum particles is excellent in properties of application and printing onto a variety of substrates.

A content of the binder resin in the organic vehicle is not particularly limited. Ordinarily, it is preferable that the content of the binder resin in the organic vehicle is greater than or equal to 0.5% by mass and less than or equal to 40% by mass.

<Glass frit>

Furthermore, the electrically conductive paste composition according to the present invention may include glass frit. It is preferable that a content of the glass frit is greater than or equal to 0.5% by mass and less than or equal to 5% by mass. The glass frit acts to enhance properties of adhesion between a film obtained after firing and a substrate. However, if the content of the glass frit exceeds 5% by mass, it is likely that segregation of glass may occur and electrical conductivity of the formed film may be reduced. An average particle diameter of the glass frit is not particularly limited unless the average particle diameter thereof exerts an adverse influence on the effects of the present invention. Ordinarily, it is preferable that the average particle diameter thereof is approximately 1 through 4 $\mu$m.

Composition and contents of components of the glass frit included in the electrically conductive paste composition according to the present invention are not particularly limited. Ordinarily, glass frit whose softening point is less than or equal to a firing temperature is used. Ordinarily, as the glass frit, $B_2O_3$-$SiO_2$-$Bi_2O_3$ based glass frit, $B_2O_3$-$SiO_2$-ZnO based glass frit, $B_2O_3$-$SiO_2$-PbO based glass frit, or the like in addition to $SiO_2$-$Bi_2O_3$-PbO based glass frit can be used.

<Metal alkoxide>

The electrically conductive paste according to the present invention may include a metal alkoxide. As a specific example of the metal alkoxide, a silicon alkoxide such as tetraethoxysilane and tetramethoxysilane; an aluminum alkoxide such as aluminum isopropoxide and aluminum ethoxide; a titanium alkoxide such as tetrabutoxy titanium; and a multimer of the above-menitoned metal alkoxide are cited. The metal alkoxide is not limited thereto, and an alkoxide of every metal such as Mg, Zn, Mn, Zr, and Ce can be used. The metal alkoxide may be included in combination with the glass frit in the electrically conductive paste according to the present invention and may be included alone in the electrically conductive paste according to the present invention. In addition, a plurality of metal alkoxides may be included in the electrically conductive paste according to the present invention.

<Others>

In addition, the electrically conductive paste composition according to the present invention can include a variety of substances unless such substances hinder the effects of the present invention. For example, the electrically conductive paste composition can be prepared by being appropriately mixed with other components such as any heretofore known resin, a viscosity modifier, a surface conditioner, an anti-settling agent, and an anti-foaming agent.

<A method of manufacturing an electrically conductive paste composition>

Although the electrically conductive paste composition according to the present invention can be manufactured by employing a method in which the components are agitated and mixed by using the heretofore known agitator or a method in which the components are kneaded by using a kneader such as a roll mill, the present invention is not limited thereto.

<A method of forming an electrically conductive film>

A material, a shape, and the like of a substrate onto which the paste composition according to the present invention is applied are not particularly limited. It is preferable that the material of the substrate is a material which can endure a heat treatment conducted in the next process. The shape of the substrate may be of a planate shape or a nonplanate shape having multiple levels or having projections and depressions, and the shape thereof is not particularly limited. As a specific example of the material of the substrate, a ceramic material, a glass material, and the like can be cited. As the ceramic material, a metal oxide such as alumina, zirconia, and titania; and as the glass material, silica glass, borosilicate glass, soda glass, or the like can be used.

In addition, a method of application of the paste composition according to the present invention is not particularly limited, and a doctor blade method, a spray coating method, a screen printing method, an ink jet method, or the like can be employed. The paste composition may be applied once or at a plurality of times, and recoating of the paste composition according to the present invention is also possible. Although a favorable thickness of a coating film varies appropriately depending on an application method and a solid content concentration, it is preferable that the favorable thickness thereof is 0.1 through 100 $\mu$m and it is further preferable that the favorable thickness thereof is 0.3 through 20 $\mu$m. If the coating film is excessively thin, flatness of the film cannot be obtained, and if the coating film is excessively thick, properties of adhesion with a substrate may become inferior.

The above-mentioned coating film may be subjected to a drying process and a degreasing process as necessary. Processing conditions of the drying and the degreasing are not particularly limited. Ordinarily, a drying temperature is 50°C through 150°C and a degreasing temperature is 250°C through 450°C. In addition, although an atmosphere in which the drying process and the degreasing process are conducted is the air in general, the present invention is not limited thereto.

Furthermore, by firing the above-mentioned coating film, an electrically conductive film can be formed. It is preferable that a firing temperature is 400°C through 640°C and it is further preferable that the firing temperature is 450°C through 550°C. In addition, an atmosphere in which the firing is conducted is not particularly limited. Even when the coating film is fired in any firing atmosphere of the air, a non-oxidizing atmosphere, a reducing atmosphere, or a vacuum, an electrically conductive film exhibiting favorable electrical conductivity and adhesion properties can be obtained. A further preferable firing atmosphere is a non-oxidizing atmosphere, a reducing atmosphere, or a vacuum. The above-mentioned non-oxidizing atmosphere may be an atmosphere which includes no oxygen but includes, for example, any gas of argon, helium, nitrogen, and the like or may be a mixed-gas atmosphere which includes a plurality of the above-mentioned gases. In addition, the firing atmosphere may be a reducing atmosphere obtained by mixing a reducing gas, for example, a hydrogen gas or the like into any of the above-mentioned gases.

<Electrically conductive film>

Furthermore, it is preferable that an average surface roughness Ra of the electrically conductive film formed by using the paste composition according to the present invention is less than or equal to 1 $\mu$m.

In the electrically conductive film according to the present invention, it is preferable that in a chart obtained by an X-ray diffraction analysis of the electrically conductive film, a peak intensity ratio of a diffraction peak corresponding to a (400) plane of $\gamma$-$Al_2O_3$ to a diffraction peak corresponding to a (200) plane of Al is less than or equal to 0.2. If this peak intensity ratio exceeds 0.2, because a contact resistance among the aluminum particles is increased due to oxidation of the flaky aluminum particles, sufficient electrical conductivity cannot be obtained.

Furthermore, it is preferable that in cross section observation of the electrically conductive film according to the present invention, an area occupancy rate of the flaky aluminum particles in a cross section of the electrically conductive film is greater than or equal to 80% and an average inclination angle of the flaky aluminum particles is less than or equal to 3°. If the area occupancy rate of the flaky aluminum particles in the cross section of the electrically conductive film is less than 80%, sufficient electrical conductivity and adhesion properties cannot be obtained. In addition, also if the average inclination angle of the flaky aluminum particles exceeds 3°, sufficient electrical conductivity and adhesion properties cannot be obtained. Accordingly, by setting the area occupancy rate of the flaky aluminum particles to be greater than or equal to 80% and the average inclination angle of the flaky aluminum particles to be less than or equal to 3°, the flaky aluminum particles come to be in close contact with a substrate, and favorable electrical conductivity and adhesion properties can be obtained.

[EXAMPLES]

Hereinafter, the present invention will be specifically described by using examples and comparison examples. However, the present invention is not limited to these examples.

First, as flaky aluminum particles used in the examples and the comparison examples, kinds of flaky aluminum particles obtained by employing the below-mentioned methods were used.

Kinds of flaky aluminum particles used in example 1, examples 6 through 14, comparison examples 1 through 4, and comparison example 6 were those obtained through pulverizing aluminum particles, obtained by employing an atomizing method according to the conventionally heretofore known method, in the presence of an organic solvent by means of a ball mill by using an oleic acid as a grinding aid. In other words, the flaky aluminum particles used in example 1, examples 6 through 14, comparison examples 1 through 4, and comparison example 6 were flaky aluminum particles having surfaces, to each of which an oleic acid as an organic film was adherent.

In addition, kinds of flaky aluminum particles used in example 2 and example 3 were those obtained through pulverizing aluminum particles, obtained by employing the atomizing method according to the conventionally heretofore known method in the same manner as mentioned above, by means of the ball mill by using a stearic acid and a stearylamine as grinding aids. In other words, the flaky aluminum particles used in example 2 and example 3 were flaky aluminum particles having surfaces, to each of which the stearic acid and the stearylamine as organic films were adherent.

Furthermore, kinds of flaky aluminum particles used in comparison example 5 and comparison example 7 were those obtained by pulverizing aluminum particles, obtained by employing the atomizing method, in the presence of an organic solvent by means of the ball mill without using any grinding aid. In other words, the flaky aluminum particles used in comparison example 5 and comparison example 7 were flaky aluminum particles having surfaces, to each of which no organic film was adherent.

Kinds of flaky aluminum particles used in example 4 and example 5 were those obtained through exfoliating an aluminum thin film, formed on a surface of a plastic film through vapor deposition, from a surface of the plastic film (on the whole surface thereof, an acrylic resin coating film as a parting agent was formed) and thereafter, by crushing the aluminum thin film. In other words, the flaky aluminum particles used in example 4 and example 5 were flaky aluminum particles having surfaces, to each of which the acrylic resin as an organic film was adherent.

The organic films which were adherent to the surfaces of the flaky aluminum particles used in the examples and the comparison examples described above are shown in the column "Organic film of Al particles" in Table 2.

(Example 1)

The flaky aluminum particles shown in example 1 in below Table 1 and Table 2 were added to an organic vehicle obtained by dissolving an ethyl cellulose resin in a mixed organic solvent of an isopropyl alcohol and toluene, and mixing was conducted by means of a well-known mixer. Further, a predetermined viscosity was adjusted by adding the mixed organic solvent of the isopropyl alcohol and the toluene, thereby preparing an electrically conductive paste composition according to the present invention. As shown in example 1 in Table 1, in the electrically conductive paste composition according to the present invention obtained as described above, a mass ratio of the flaky aluminum particles was 17.3% by mass, and the total of contents of the organic vehicle and the solvent was 82.7% by mass. The obtained electrically conductive paste composition was applied onto a glass substrate by employing a doctor blade method, thereby forming a coating film. A thickness of the coating film was controlled to be within a range of 1 through 2 μm.

This coating film was dried in the atmosphere at a temperature of 50°C for 10 minutes, and thereafter, was further subjected to a degreasing process in the atmosphere at a temperature of 350°C for 60 minutes by means of a hot air dryer. The coating film processed as described above was fired in an argon gas atmosphere in a firing furnace at a temperature of 550°C for 60 minutes, thereby forming an electrically conductive film.

With respect to the obtained electrically conductive film, a sheet resistance, adhesiveness, an average surface roughness were measured by employing the below-described method. The result is shown in Table 1.

(Examples 2 through 6)

Kinds of electrically conductive paste compositions according to the present invention were prepared in the same manner as in example 1 by using the kinds of flaky aluminum particles shown in below Table 1 and Table 2; these electrically conductive paste compositions were applied onto glass substrates, thereby forming coating films; and these coating films were fired, thereby forming electrically conductive films. With respect to each of the obtained kinds of the electrically conductive films, a sheet resistance, adhesiveness, an average surface roughness were measured by employing the below-described method. The result is shown in Table 1.

(Example7)

One part by mass of $B_2O_3$-$SiO_2$-$Bi_2O_3$ based glass frit was added to 100 parts by mass of an electrically conductive paste composition prepared in example 6, thereby preparing an electrically conductive paste composition according to the present invention. In the same manner as in example 6, this electrically conductive paste composition was applied onto a glass substrate, thereby forming a coating film, and this coating film was fired, thereby forming an electrically conductive film. With respect to the obtained electrically conductive film, a sheet resistance, adhesiveness, an average surface roughness were measured by employing the below-described method. The result is shown in Table 1.

(Example 8)

Flaky aluminum particles shown in example 8 in below Table 1 and Table 2 were added to an organic vehicle obtained by dissolving an acrylic resin in a mixed organic solvent of terpineol and toluene, and mixing was conducted by means of a well-known mixer, thereby preparing an electrically conductive paste composition according to the present invention. A mass ratio of the aluminum particles in this electrically conductive paste composition was 25.0% by mass. In the same manner as in example 1, this electrically conductive paste composition was applied onto a glass substrate, thereby forming a coating film, and this coating film was fired, thereby forming an electrically conductive film. With respect to the obtained electrically conductive film, a sheet resistance, adhesiveness, an average surface roughness were measured by employing the below-described method. The result is shown in Table 1.

(Example 9)

An electrically conductive paste composition according to the present invention was prepared in the same manner as in example 1 by using flaky aluminum particles shown in example 9 in below Table 1 and Table 2. In the same manner as in example 1, this electrically conductive paste composition was applied onto an alumina substrate, instead of the glass substrate, thereby forming a coating film, and this coating film was fired, thereby forming an electrically conductive film. With respect to the obtained electrically conductive film, a sheet resistance, adhesiveness, an average surface roughness were measured by employing the below-described method. The result is shown in Table 1.

(Example 10)

An electrically conductive paste composition according to the present invention was prepared in the same manner as in example 1 by using flaky aluminum particles shown in example 10 in below Table 1 and Table 2, and the electrically conductive paste composition was applied onto a glass substrate, thereby forming a coating film. This coating film was fired in the firing furnace in a nitrogen gas atmosphere, instead of the argon gas atmosphere, at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Example 11)

An electrically conductive paste composition according to the present invention was prepared in the same manner as in example 1 by using flaky aluminum particles shown in example 11 in below Table 1 and Table 2, and the electrically conductive paste composition was applied onto a glass substrate, thereby forming a coating film. This coating film was fired in the firing furnace in a vacuum atmosphere, instead of the argon gas atmosphere, at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Example 12)

Although in the same manner as in example 1, an electrically conductive paste composition according to the present invention was prepared, flaky aluminum particles and flaky silver particles (an average thickness: 0.1 $\mu$m, an average particle diameter: 5 $\mu$m), whose contents are shown in example 12 in below Table 1 and Table 2, were used as electrically conductive powders. This electrically conductive paste composition was applied onto a glass substrate, thereby forming a coating film. This coating film was fired in the firing furnace in the argon gas atmosphere at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Example 13)

An electrically conductive film was formed in the same manner as in example 7 except that 3 parts by mass of tetraethoxysilane (TEOS for short), instead of the glass frit, were added. With respect to the obtained electrically conductive film, a sheet resistance, adhesiveness, an average surface roughness were measured by employing the below-described method. The result is shown in Table 1.

(Example 14)

An electrically conductive film was formed in the same manner as in example 6 except that a firing atmosphere was the air. With respect to the obtained electrically conductive film, a sheet resistance, adhesiveness, an average surface roughness were measured by employing the below-described method. The result is shown in Table 1.

(Comparison examples 1 through 3)

Electrically conductive paste compositions were prepared in the same manner as in example 1 except that kinds of flaky aluminum particles shown in comparison examples 1 through 3 in below Table 1 and Table 2 were used; these electrically conductive paste compositions were applied onto glass substrates, thereby forming coating films; and these coating films were fired, thereby forming electrically conductive films. With respect to each of the obtained kinds of the electrically conductive films, a sheet resistance, adhesiveness, an average surface roughness were measured by employing the below-described method. The result is shown in Table 1.

(Comparison example 4)

Although in the same manner as in example 1, an electrically conductive paste composition was prepared, flaky aluminum particles and flaky silver particles (an average thickness: 0.1 $\mu$m, an average particle diameter: 5 $\mu$m), whose contents are shown in comparison example 4 in below Table 1 and Table 2, were used as electrically conductive powders. This electrically conductive paste composition was applied onto a glass substrate, thereby forming a coating film. This coating film was fired in the firing furnace in the argon gas atmosphere at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Comparison example 5)

An electrically conductive paste composition was prepared in the same manner as in example 1 except that flaky aluminum particles including no organic film, as shown in Table 1 and Table 2, were used as an electrically conductive powder. This electrically conductive paste composition was applied onto a glass substrate, thereby forming a coating film. This coating film was fired in the firing furnace in the argon gas atmosphere at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Comparison example 6)

An electrically conductive paste composition was prepared in the same manner as in example 1 except that flaky aluminum particles shown in Table 1 and Table 2 were used as an electrically conductive powder. This electrically conductive paste composition was applied onto a glass substrate, thereby forming a coating film. This coating film was fired in the firing furnace in the argon gas atmosphere at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

(Comparison example 7)

An electrically conductive paste composition was prepared in the same manner as in example 1 except that flaky aluminum particles including no organic film, as shown in Table 1 and Table 2, were used as an electrically conductive powder. This electrically conductive paste composition was applied onto a glass substrate, thereby forming a coating film. This coating film was fired in the firing furnace in the argon gas atmosphere at the temperature of 550°C for 60 minutes, thereby forming an electrically conductive film. With respect to the obtained electrically conductive film, a sheet resistance, adhesiveness, an average surface roughness were measured by employing the below-described method. The result is shown in Table 1.

In the above-described examples 1 through 14 and comparison examples 1 through 7, each average thickness and each average particle diameter of each of the kinds of the flaky aluminum particles; each oxygen content of each of the kinds of the flaky aluminum particles with respect to each unit surface area; each average aspect ratio, which is a ratio of an average particle diameter of each of the kinds of the flaky aluminum particles to an average thickness of each thereof, and each sheet resistance, each adhesiveness, and each average surface roughness of each of the kinds of the obtained electrically conductive films, which are shown in below Table 1, were measured or evaluated as described below.

<Average thickness>

As described in Japanese Patent Application Laid-Open Publication No. 06-200191 and International Publication No. WO 2004/026970, the average thickness of the flaky aluminum particles can be obtained by employing a calculation method in which a water covering area of the flaky aluminum powder is measured and a value of the water covering area is substituted in specific equations. A specific calculation method is as follows.

The flaky aluminum particles were cleaned by using acetone; thereafter, a mass w (g) of the dried flaky aluminum particles and a covering area A (cm$^2$) resulting when the flaky aluminum particles were evenly floated on a water surface were measured; and a WCA (water covering area) was calculated by using the below equation 1. Next, a value of the WCA was substituted in the below equation 2, thereby calculating the average thickness of the flaky aluminum particles.

$$\text{Equation 1: WCA } (\text{cm}^2/\text{g}) = A\ (\text{cm}^2)\ /\ w\ (\text{g})$$

$$\text{Equation 2: average thickness } (\mu m) = 10^4\ /\ (2.5\ (\text{g/cm}^3) \times \text{WCA})$$

The above-described calculation method of the average thickness is described in, for example, Aluminum Paint and Powder, written by J. D. Edeards and R. I. Wray, the third edition, published by Reinhold Publishing Corp, New York (1955), Pages 16 through 22 and the like.

Since it was difficult to measure the above-mentioned WCA of ultrathin aluminum particles (each thickness thereof is less than or equal to 0.06 $\mu$m) due to particle agglomeration, an average thickness of the ultrathin aluminum particles was calculated by obtaining an average value of thicknesses of randomly selected 20 particles, the thicknesses measured in a photograph of the ultrathin aluminum particles shot by an atomic force microscope (AFM).

<Average particle diameter>

An average particle diameter of the flaky aluminum particles was measured by employing a laser diffraction method and using Microtrac X100 (a particle size analyzer produced by NIKKISO CO., LTD).

<Oxygen content>

An oxygen content [mg/m$^2$] of the flaky aluminum particles was calculated by obtaining a ratio between an oxygen content measured by employing an inert gas fusion infrared absorption method and a specific surface area measured by employing a nitrogen adsorption BET method (oxygen content [mg/g] /specific surface area [m2/g]).

The specific surface area of the ultrathin aluminum particles (each thickness thereof is less than or equal to 0.06 $\mu$m) was calculated by substituting the average thickness obtained by employing the above-mentioned method in the below equation 3.

$$\text{Equation 3: specific surface area } (\text{m}^2/\text{g}) = 2 \times 10^4\ /\ (2.7 \times \text{average thickness } (\mu m))$$

<Average aspect ratio>

An average aspect ratio of the flaky aluminum particles was calculated by obtaining a ratio between the average particle diameter measured by employing the laser diffraction method and the average thickness measured by employing the above-mentioned method (average particle diameter [$\mu$m] / average thickness [$\mu$m]).

<Sheet resistance>

A sheet resistance of each of the obtained electrically conductive films was measured by using a 4-point-probe-type surface resistance measuring system (a RG-5-model sheet resistance measuring system produced by NAPSON CORPORATION). Measuring conditions were: a voltage was 4 mV; a current was 100 mA; and a load exerted on a surface of each of the electrically conductive films was 200 grf (1.96N).

<Adhesiveness>

Adhesiveness of each of the obtained electrically conductive films with each of the substrates was obtained in a manner such that a cellophane adhesive tape (registered trademark: CT-24 manufactured by Nichiban Co., Ltd.) was attached to each of the electrically conductive films and was pulled at an angle of 45 degrees, and a degree of peeling-off of each of the electrically conductive film (the aluminum particles in each of the electrically conductive films) was visually observed. In accordance with the observation result, evaluations of "fine": without peeling-off and "failure": with peeling-off were made.

\<Average surface roughness\>

An average surface roughness Ra of each of the electrically conductive films was measured by using a surface roughness measuring instrument (SURFCOM 1400D produced by TOKYO SEIMITU CO., LTD.).

[Table 1]

| Example | Aluminum particles | | | | | Glass Frit or Metal alkoxide | Silver particle content | Organic vehicle + Solvent | | Substrate material | Firing Atmosphere | Flectrically conductive film | | |
|---|---|---|---|---|---|---|---|---|---|---|---|---|---|---|
| | Thickness | Particle diameter | Aspect ratio | Oxygen content | Content | | | Binder kind | Content | | | Sheet resistance | Adhesiveness | Surface roughness Ra |
| | (μm) | (μm) | | (mg/m²) | (% by mass) | | (% by mass) | | (% by mass) | | | (Ω/sq.) | | (μm) |
| Example 1 | 0.7 | 24.8 | 35 | 7 | 17.3 | Not added | Not added | Cellulose based | 82.7 | Glass | Argon | 65 | Fine | 0.91 |
| Example 2 | 0.5 | 18.8 | 40 | 7 | 17.3 | Not added | Not added | Cellulose based | 82.7 | Glass | Argon | 48 | Fine | 0.83 |
| Example 3 | 0.3 | 10.5 | 42 | 7 | 17.3 | Not added | Not added | Cellulose based | 82.7 | Glass | Argon | 28 | Fine | 0.69 |
| Example 4 | 0 | 11.9 | 298 | 10 | 14.5 | Not added | Not added | Cellulose based | 85.5 | Glass | Argon | 262 | Fine | 0.48 |
| Example 5 | 0 | 13.7 | 343 | 12 | 14.5 | Not added | Not added | Cellulose based | 85.5 | Glass | Argon | 384 | Fine | 0.62 |
| Example 6 | 0.1 | 15.2 | 253 | 4 | 14.5 | Not added | Not added | Cellulose based | 85.5 | Glass | Argon | 23 | Fine | 0.55 |
| Example 7 | 0.1 | 15.2 | 253 | 4 | 14.5 | Glass frit | Not added | Cellulose based | 85.5 | Glass | Argon | 32 | Fine | 0.55 |
| Example 8 | 0.1 | 15.2 | 253 | 4 | 25.0 | Not added | Not added | Acryl based | 75.0 | Glass | Argon | 40 | Fine | 0.49 |
| Example 9 | 0.1 | 15.2 | 253 | 4 | 14.5 | Not added | Not added | Cellulose based | 85.5 | Alumina | Argon | 29 | Fine | 0.50 |
| Example 10 | 0.1 | 15.2 | 253 | 4 | 14.5 | Not added | Not added | Cellulose based | 85.5 | Glass | Nitrogen | 52 | Fine | 0.56 |
| Example 11 | 0.1 | 15.2 | 253 | 4 | 14.5 | Not added | Not added | Cellulose based | 85.5 | Glass | Vacuum | 28 | Fine | 0.48 |
| Example 12 | 0.1 | 15.2 | 253 | 4 | 13.6 | Not added | 2.4 | Cellulose based | 84.0 | Glass | Argon | 19 | Fine | 0.55 |

| Example | Aluminum particles | | | | | Glass Frit or Metal alkoxide | Silver particle content | Organic vehicle + Solvent | | Substrate material | Firing Atmosphere | Electrically conductive film | | |
|---|---|---|---|---|---|---|---|---|---|---|---|---|---|---|
| | Thickness | Particle diameter | Aspect ratio | Oxygen content | Content | | | Binder kind | Content | | | Sheet resistance | Adhesiveness | Surface roughness Ra |
| | (μm) | (μm) | | (mg/m²) | (% by mass) | | (% by mass) | | (% by mass) | | | (Ω/sq.) | | (μm) |
| Example 13 | 0.1 | 15.2 | 253 | 4 | 14.5 | TEOS | Not added | Cellulose based | 85.5 | Glass | Argon | 28 | Fine | 0.51 |
| Example 14 | 0.1 | 15.2 | 253 | 4 | 14.5 | Not added | Not added | Cellulose based | 85.5 | Glass | Pair | 30 | Fine | 0.53 |
| Comparison Example 1 | 1 | 26.3 | 27 | 6 | 17.3 | Not added | Not added | Cellulose based | 82.7 | Glass | Argon | 234 | Failure | 1.30 |
| Comparison Example 2 | 0 | 17.5 | 438 | 17 | 14.5 | Not added | Not added | Cellulose based | 85.5 | Glass | Argon | 757 | Fine | 0.78 |
| Comparison Example 3 | 0 | 22.0 | 550 | 19 | 14.5 | Not added | Not added | Cellulose based | 85.5 | Glass | Argon | 906 | Fine | 0.95 |
| Comparison Example 4 | 0 | 17.5 | 438 | 17 | 13.6 | Not added | 2.4 | Cellulose based | 84.0 | Glass | Argon | 645 | Fine | 0.68 |
| Comparison Example 5 | 1.1 | 21.1 | 20 | 14 | 14.5 | Not added | Not added | Cellulose based | 82.7 | Glass | Argon | 1300 | Failure | 1.51 |
| Comparison Example 6 | 0 | 11.9 | 438 | 20 | 14.5 | Not added | Not added | Cellulose based | 84.0 | Glass | Argon | 2200 | Fine | 0.47 |
| Comparison Example 7 | 1.1 | 21.1 | 20 | 14 | 14.5 | Not added | Not added | Cellulose based | 84.0 | Glass | Argon | 1600 | Failure | 1.12 |

EP 2 405 449 B1

14

It is seen from the results of examples 1 through 14 shown in Table 1 that when the electrically conductive film is formed on the substrate by using the flaky aluminum particles, as the electrically conductive powder contained in the paste composition, whose average thickness is less than or equal to 0.8 μm and whose ratio of the oxygen content to the unit surface area of the particles is less than or equal to 15 mg/m$^2$, the electrically conductive film which exhibits the relatively low sheet resistance, has the average surface roughness Ra less than or equal to 1.00 μm, and is excellent in the electrical conductivity, the surface smoothness properties, and the properties of adhesion with a base material can be obtained.

In particular, when example 1 and comparison example 1 in which levels of the oxygen contents were similar to each other are compared, it is seen that in example 1 in which the average thickness of the flaky aluminum particles was less than or equal to 0.8 μm, the average surface roughness Ra was less than or equal to 1.00 μm, and the adhesiveness of the electrically conductive film with the substrate is fine, as compared with comparison example 1 in which the average thickness of the flaky aluminum particles exceeded 0.8 μm.

When examples 4 and 5 as well as comparison examples 2 and 3 in which the degrees of average thicknesses of the flaky aluminum particles were similar to one another are compared, it is seen that in examples 4 and 5 in which oxygen contents were less than or equal to 15 mg/m$^2$, the sheet resistances are small, as compared with comparison examples 2 and 3 in which the oxygen contents exceeded 15 mg/m$^2$.

When example 12 and comparison example 4 in which the mixture of the flaky aluminum particles and flaky silver particles were used, it is seen that in example 12 in which the oxygen content was less than or equal to 15 mg/m$^2$, the sheet resistance is small, as compared with comparison example 4 whose oxygen content exceeded 15 mg/m$^2$.

With respect to the electrically conductive films obtained in examples 1 through 14 and comparison examples 1 through 7, the below-described analyses were conducted. The obtained result is shown in Table 2.

<Al$_2$O$_3$/Al peak intensity ratio in X-ray diffraction analysis chart>

With each of the obtained electrically conductive films being applied onto each of the substrates and fired, a powder X-ray diffraction analysis was conducted by using an X-ray diffraction system (RINT2000 produced by Rigaku Corporation). In the obtained X-ray diffraction chart, a peak intensity (count value) PI corresponding to a (200) plane of Al and a peak intensity (count value) P2 corresponding to a (400) plane of γ-Al$_2$O$_3$ were read out and a value of P2/P1 was calculated. The result is shown in Table 2.

<An area occupancy rate of flaky aluminum particles in a cross section of an electrically conductive film>

With each of the obtained electrically conductive films being applied onto each of the substrates and fired, each of the electrically conductive films was cut by means of a diamond cutter and polished, and thereafter, a distribution of Al in a cross section was observed by using an X-ray microanalyzer. With respect to images of the observed 10 particles, an area occupancy rate of each of the kinds of flaky aluminum particles was calculated by using image analysis software (Image-Pro Plus Ver.4). The values are shown in Table 2.

<An average inclination angle of flaky aluminum particles>

With respect to the images of the 10 particles used in the above-mentioned measurement of the area occupancy rate of each of the kinds of flaky aluminum particles in the cross section of each of the electrically conductive films, inclination angles of the flaky aluminum particles with respect to faces of the glass substrates was individually measured by using the image analysis software (the same one as mentioned above) and an average value thereof was calculated, thereby obtaining each average inclination angle. The values are shown in Table 2.

[Table 2]

|  | Organic film of Al particles | Al$_2$O$_3$/Al peak intensity ratio | Area occupancy rate of Al in cross section (%) | Average inclination angle of flaky Al (°) |
|---|---|---|---|---|
| Example 1 | Oleic acid | 0.05 | 85 | 1.4 |
| Example 2 | Stearic acid | 0.04 | 89 | 1.3 |
| Example 3 | Stearylamine | 0.08 | 92 | 0.8 |
| Example 4 | Acrylic resin | 0.10 | 87 | 1.5 |
| Example 5 | Acrylic resin | 0.14 | 86 | 1.6 |

(continued)

|  | Organic film of Al particles | Al$_2$O$_3$/Al peak intensity ratio | Area occupancy rate of Al in cross section (%) | Average inclination angle of flaky Al (°) |
|---|---|---|---|---|
| Example 6 | Oleic acid | 0.08 | 93 | 0.7 |
| Example 7 | Oleic acid | 0.12 | 82 | 1.7 |
| Example 8 | Oleic acid | 0.08 | 92 | 0.8 |
| Example 9 | Oleic acid | 0.09 | 94 | 0.8 |
| Example 10 | Oleic acid | 0.10 | 93 | 0.8 |
| Example 11 | Oleic acid | 0.11 | 93 | 0.8 |
| Example 12 | Oleic acid | 0.13 | 82 | 1.2 |
| Example 13 | Oleic acid | 0.09 | 88 | 1.2 |
| Example 14 | Oleic acid | 0.10 | 94 | 0.8 |
| Comparison Example 1 | Oleic acid | 0.18 | 73 | 5.4 |
| Comparison Example 2 | Oleic acid | 0.35 | 94 | 0.7 |
| Comparison (Example 3 | Oleic acid | 0.44 | 91 | 0.8 |
| Comparison Example 4 | Oleic acid | 0.31 | 94 | 0.7 |
| Comparison Example 5 | None | 0.55 | 75 | 6.7 |
| Comparison Example 6 | Oleic acid | 0.23 | 89 | 0.7 |
| Comparison Example 7 | None | 0.11 | 77 | 3.4 |

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

INDUSTRIAL APPLICABILITY

An electrically conductive paste composition according to the present invention and an electrically conductive film formed by using this electrically conductive paste composition are applicable to formation of electrodes and wired in a variety of substrates and electronic devices.

**Claims**

1.   An electrically conductive paste composition, comprising flaky aluminum particles as an electrically conductive powder, the flaky aluminum particles having an average thickness being less than or equal to 0.8 $\mu$m and having a ratio of an oxygen content to a unit surface area of the flaky aluminum particles being less than or equal to 15 mg/m$^2$.

2.   The electrically conductive paste composition according to claim 1, wherein an average aspect ratio is greater than or equal to 30 and less than or equal to 500, the average aspect ratio being a ratio of an average particle diameter of the flaky aluminum particles to the average thickness of the flaky aluminum particles.

3. The electrically conductive paste composition according to claim 1, wherein each of the flaky aluminum particles is covered with an organic film.

4. The electrically conductive paste composition according to claim 1, wherein the organic film includes at least one kind selected from the group consisting of a fatty acid, an aliphatic amine, an aliphatic alcohol, an aliphatic ester compound, and a resin.

5. The electrically conductive paste composition according to claim 1, further comprising at least one kind selected from the group consisting of an organic vehicle, glass frit, and a metal alkoxide.

6. An electrically conductive film formed by using the electrically conductive paste composition according to claim 1, the electrically conductive film having an average surface roughness Ra being less than or equal to 1 $\mu$m.

7. The electrically conductive film according to claim 6, wherein in a chart obtained by an X-ray diffraction analysis of the electrically conductive film, a peak intensity ratio of a diffraction peak corresponding to a (400) plane of $\gamma$-Al$_2$O$_3$ to a diffraction peak corresponding to a (200) plane of Al is less than or equal to 0.2.

8. The electrically conductive film according to claim 6, wherein in cross section observation of the electrically conductive film, an area occupancy rate of the flaky aluminum particles in a cross section of the electrically conductive film is greater than or equal to 80% and an average inclination angle of the flaky aluminum particles is less than or equal to 3°.

9. The electrically conductive paste composition according to claim 1, wherein the electrically conductive powder consists of flaky aluminum particles.


**Patentansprüche**

1. Elektrisch leitende Pastenzusammensetzung, umfassend plättchenförmige Aluminiumpartikel als ein elektrisch leitendes Pulver, wobei die plättchenförmigen Aluminiumpartikel eine mittlere Dicke aufweisen, die kleiner als oder gleich 0,8 $\mu$m ist, und ein Verhältnis eines Sauerstoffgehalts zu einer Oberflächeneinheit der plättchenförmigen Aluminiumpartikel aufweisen, das kleiner als oder gleich 15 mg/m$^2$ ist.

2. Elektrisch leitende Pastenzusammensetzung gemäß Anspruch 1, wobei ein mittleres Aspektverhältnis größer als oder gleich 30 und kleiner als oder gleich 500 ist, wobei das mittlere Aspektverhältnis ein Verhältnis eines mittleren Partikeldurchmessers der plättchenförmigen Aluminiumpartikel zu der mittleren Dicke der plättchenförmigen Aluminiumpartikel ist.

3. Elektrisch leitende Pastenzusammensetzung gemäß Anspruch 1, wobei jedes von den plättchenförmigen Aluminiumpartikeln mit einem organischen Film bedeckt ist.

4. Elektrisch leitende Pastenzusämmensetzung gemäß Anspruch 1, wobei der organische Film wenigstens eine Art, ausgewählt aus der Gruppe bestehend aus einer Fettsäure, einem aliphatischen Amin, einem aliphatischen Alkohol, einer aliphatischen Esterverbindung und einem Harz, einschließt.

5. Elektrisch leitende Pastenzüsammensetzung gemäß Anspruch 1, außerdem umfassend wenigstens eine Art, ausgewählt aus der Gruppe bestehend aus einem organischen Bindemittel, Glasfritte und einem Metallalkoxid.

6. Elektrisch leitender Film gebildet durch Verwenden der elektrisch leitenden Pastenzusammensetzung gemäß Anspruch 1, wobei der elektrisch leitende Film eine mittlere Oberflächenrauigkeit Ra aufweist, die kleiner als oder gleich 1 $\mu$m ist.

7. Elektrisch leitender Film gemäß Anspruch 6, wobei in einem Diagramm, das durch eine Röntgenbeugungsanalyse - des elektrisch leitenden Films erhalten wird, ein Peakintensitätsverhältnis eines Beugungspeaks, der einer (400)-Ebene von $\gamma$-Al$_2$O$_3$ entspricht, zu einem Beugungspeak, der einer (200)-Ebene von Al entspricht, kleiner als oder gleich 0,2 ist.

8. Elektrisch leitender Film gemäß Anspruch 6, wobei bei einer Querschnittsbeobachtung des elektrisch leitenden Films, ein Flächenbelegungsgrad der plättchenförmigen Aluminiumpartikel in einem Querschnitt des elektrisch leitenden Films größer als oder gleich 80 % ist und ein mittlerer Neigungswinkel der plättchenförmigen Aluminiumpartikel kleiner als oder gleich 3° ist.

9.  Elektrisch leitende Pastenzusammensetzung gemäß Anspruch 1, wobei das elektrisch leitende Pulver aus plättchenförmigen Aluminiumpartikeln besteht.

**Revendications**

1.  Composition de pâte électriquement conductrice, comprenant des particules floconneuses d'aluminium comme poudre électriquement conductrice, les particules floconneuses d'aluminium présentant une épaisseur moyenne inférieure ou égale à 0,8 $\mu$m et présentant un rapport d'une teneur en oxygène à une surface unitaire des particules floconneuses d'aluminium inférieur ou égal à 15 mg/m$^2$.

2.  Composition de pâte électriquement conductrice selon la revendication 1, un rapport d'aspect moyen étant supérieur ou égal à 30 et inférieur ou égal à 500, le rapport d'aspect moyen étant un rapport d'un diamètre moyen de particule des particules floconneuses d'aluminium à l'épaisseur moyenne des particules floconneuses d'aluminium.

3.  Composition de pâte électriquement conductrice selon la revendication 1, chacune des particules floconneuses d'aluminium étant recouverte d'un film organique.

4.  Composition de pâte électriquement conductrice selon la revendication 1, le film organique comprenant au moins un type sélectionné dans le groupe constitué d'un acide gras, d'une amine aliphatique, d'un alcool aliphatique, d'un composé ester aliphatique, et d'une résine.

5.  Composition de pâte électriquement conductrice selon la revendication 1, comprenant en outre au moins un type sélectionné dans le groupe constitué d'un véhicule organique, d'une fritte de verre, et d'un alcoxyde métallique.

6.  Film électriquement conducteur formé en utilisant la composition de pâte électriquement conductrice selon la revendication 1, le film électriquement conducteur présentant une rugosité moyenne de surface Ra inférieure ou égale à 1 $\mu$m.

7.  Film électriquement conducteur selon la revendication 6, dans lequel dans un diagramme obtenu par analyse de diffraction des rayons X du film électriquement conducteur, un rapport d'intensité pic d'un pic de diffraction correspondant à un plan (400) de $\gamma$-Al$_2$O$_3$ à un pic de diffraction correspondant à un plan (200) de Al est inférieur ou égal à 0,2.

8.  Film électriquement conducteur selon la revendication 6, dans lequel dans une observation transversale du film électriquement conducteur, un taux d'occupation de surface des particules floconneuses d'aluminium dans un sens transversal du film électriquement conducteur est supérieur ou égal à 80 % et un angle moyen d'inclinaison des particules floconneuses d'aluminium est inférieur ou égal à 3°

9.  Composition de pâte électriquement conductrice selon la revendication 1, la poudre électriquement conductrice étant constituée de particules floconneuses d'aluminium.

## REFERENCES CITED IN THE DESCRIPTION

### Patent documents cited in the description

- JP 2008108716 A
- JP 5298917 A
- JP 2005001193 A
- JP 6200191 A
- WO 2004026970 A

### Non-patent literature cited in the description

- **J. D. EDEARDS ; R. I. WRAY.** Aluminum Paint and Powder. Reinhold Publishing Corp, 1955, 16-22